# EUROPEAN PATENT APPLICATION

(11) **EP 1 662 235 A2**
(43) Date of publication of application: **31.05.2006**
(21) Application number: 05252310.7
(22) Date of filing: 14.04.2005
(51) Int. Cl.: G01D 11/30, G01P 15/18

(54) **Acceleration sensor**

(30) Priority: 26.10.2004 JP 2004311453
(71) Applicant: Fujitsu Media Devices Limited, Yokohama-shi, Kanagawa 222-0033 (JP); FUJITSU LIMITED, Kawasaki-shi, Kanagawa 211-8588 (JP)
(72) Inventor: Tanaka, Hiroshi c/o Fujitsu Media Devices Ltd, Kohoku-ku Yokohama-shi Kanagawa 222-0033 (JP); Nagata, Kenji c/o Fujitsu Media Devices Ltd, Kohoku-ku Yokohama-shi Kanagawa 222-0033 (JP); Ono, Masaaki c/o Fujitsu Media Devices Ltd, Kohoku-ku Yokohama-shi Kanagawa 222-0033 (JP); Miyashita, Tsutomu c/o Fujitsu Media Devices Ltd, Kohoku-ku Yokohama-shi Kanagawa 222-0033 (JP); Yamada, Sumio c/o Fujitsu Media Devices Ltd, Yokohama-shi Kanagawa 222-0033 (JP); Ishikawa, Hiroshi c/o Fujitsu Ltd, Nakahara-ku Kawasaki-shi Kanagawa 211-85 (JP)
(74) Representative: Stebbing, Timothy Charles

(57) **Abstract**

An acceleration sensor with reduced noise that resolves the problem of stress arising from a difference in thermal expansion coefficients is provided. The acceleration sensor detects acceleration in three-axis directions in a three-dimensional coordinate system, and includes a frame (1) having four sides that is integrally formed by a semiconductor substrate; a weight portion (2) that is positioned within the frame; and four beam portions (3), corresponding with each of the four sides, one end of which is connected to the weight portion to support the weight portion and the other end of which is connected to the center of the corresponding side of the four sides,wherein a detection element (5) that detects flexure of the beam portions (3) that corresponds to the acceleration acting on the weight portion (2) is formed on each of the four beam portions; a pair of joint portions (7a,7b) that are formed with a gap there between are formed on each of the four sides of the frame (1); and the gap between the pair of joint portions formed on one side has a predetermined length with the center of the one side as the point of symmetry.

## Description

The present invention relates to an acceleration sensor. More particularly, the present invention relates to an acceleration sensor that is capable of detecting the respective acceleration on three axes and implements an improvement in the temperature characteristic.

In order to implement various types of control in moving bodies such as automobiles and ships, robots, mechanical fabrication devices, or mobile devices that are grasped and used byauser, such as notebook PCs, portable telephones, PDA (Personal Digital Assistant), DVC (Digital Video Camera), DSC (Digital Still Camera), for example, it is essential to detect the stress acting on all or part of the target body in correspondence with the objective of the control. By sensing the stress on the basis of the acceleration acting on all or part of the target, it is possible to sense the acceleration.

A variety of devices for detecting this stress or acceleration have been conventionally developed, of which one device is known in which a gauge resistor is formed on the semiconductor substrate and which converts the mechanical strain produced on the basis of a force that is supplied from outside and acts on an weight portion to sway, into an electrical signal as a result of the piezoresistive effect ("Development of three-spindle sensor" 'Invention' Journal pages 52 to 63, published by the Invention Society on September 2003).

In addition, the fact that it is also possible to use a change in the electrostatic capacity corresponding with strain instead of using the piezoresistive effect of the gauge resistor is explained in "Development of three-spindle sensor" 'Invention' Journal pages 52 to 63, published by the Invention Society on September 2003.

In particular, the feature of the invention that is described in "Development of three-spindle sensor" 'Invention' Journal pages 52 to 63, published by the Invention Society on September 2003 is the fact that it is possible, by means of force sensors for a plurality of axial directions formed on a semiconductor substrate, to constitute sensors of a plurality of types, that is, sensors of four types, namely, a three-axis force sensor, a three-axis acceleration sensor, a three-axis angular speed sensor, and a six-axis motion sensor by means of one device.

Proposals have been made for a variety of problems relating to semiconductor acceleration sensors that use the principles that appear in "Development of three-spindle sensor" 'Invention' Journal pages 52 to 63, published by the Invention Society on September 2003. One of these various problems is that a large unforeseen shock can sometimes be applied as a result of the environment in which the acceleration sensor is employed (depending on what kind of device the acceleration sensor is used in). In such a case, there is a risk that the weight portion will be displaced greatly and the gauge resistor will be accordingly damaged.

In order to eliminate this inconvenience, a constitution in which a stopper that limits the displacement of the weight portion is provided has been proposed (Japanese Patent Application Laid Open No. 2000-187041).

Meanwhile, there is the problem of detection errors caused by stress that arises from the difference in the thermal expansion coefficients of the parts constituting the acceleration sensor, for example, the difference in the thermal expansion coefficients of the semiconductor substrate and the stopper, or to the difference in the thermal expansion coefficients of the semiconductor substrate and electrode pads that are provided in order to lead the output of the detection element to the outside.

Furthermore, one constitution for resolving the problem arising from this difference in the thermal expansion coefficients has been proposed (Japanese Patent Application No. 2000-304762). The invention appearing in Japanese Patent Application No. 2000-304762 is a constitution that forms a stopper by means of the tips of support portions that extend from the four corners of a rectangular support frame. As a result, the problem arising from the difference in the thermal expansion coefficients of the semiconductor substrate and the stopper is eliminated by reducing the area of the joint between the frame and the stopper.

In the case of the invention appearing in Japanese Patent Application No. 2000-304762, because the stopper extends from the four corners, the pads used in the electrical connection on the frame are concentrated in the vicinity of a flexible or beam portion. As a result, a constitution results in which thermal stress arising from the difference in the thermal expansion coefficients of the frame and the pads is readily produced in the beam portion.

Therefore, it is desirable to overcome the problem of stress that arises from the difference in the thermal expansion coefficients and to provide an acceleration sensor that eliminates the inconvenience of this conventional invention.

According to the presentinvention, there is provided an acceleration sensor that detects acceleration in three-axis directions in a three-dimensional coordinate system, and includes a frame having four sides that is integrally formed by a semiconductor substrate; a weight portion that is positioned within the frame; and four beam portions corresponding with each of the four sides one end of which is connected to the weight portion to support the weight portion and the other end of which is connected to the center of the corresponding side of the four sides, wherein a detection element that detects flexure of the beam portions that corresponds to the acceleration acting on the weight portion is formed on each of the four beam portions; a pair of joint portions that are formed with a gap there between are formed on each of the four sides of the frame; and the gap between the pair of joint portions formed on one side has a predetermined length with the center of the one side as the point of symmetry.

In the above acceleration sensor, preferably each of the pair of joint portions comprises a plurality of electrode terminals connected to a predetermined electrode lead that is linked to the detection element and the plurality of electrode elements are disposed at equal intervals along the corresponding side.

Also, preferably, the offset voltage that is detected by the detection element is adjusted by means of the size of the gap between the pair of joint portions.

In a first embodiment of the invention, the frame has a predetermined thickness and comprises, on each of the four sides thereof, a recess, in which a region that is narrower than the predetermined thickness is formed uniformly to a predetermined length along the side of the frame on the opposite side from the face where the pair of joint portions is formed; and the recess, which is joined to a mount opposite the opposite side, forms a space groove that is between the substrate and the frame.

In a second embodiment of the invention, the frame has a predetermined thickness and is formed by means of a recess in which at least a region where the pair of joint portions is formed is formed uniformly to a predetermined length that is narrower than the predetermined thickness along a side of the frame; and the recess, which is joined to a stopper substrate opposite the pair of joint portions, forms a space groove that is between the stopper substrate and the frame.

In the above first embodiment, preferably, the mount that is joined to the frame is a circuit substrate, a package bottom portion or a package cover.

Meanwhile, in the above-mentioned second embodiment, it is preferred that the offset voltage that is detected by the detection element is adjusted by means of the predetermined length of the recess.

In either embodiment, a groove portion may be formed in the reverse side of the frame in a direction that matches the direction of the beam portion, in the center of the recess of the frame.

Alternatively, groove portions may be formed in positions corresponding with the four corners of the frame on the surface side of the frame.

The features of the present invention will become more evident from the embodiments of the invention that are described in accordance with the drawings herein below.

The present invention makes it possible to provide an acceleration sensor that resolves the problem of stress arising from the difference in the thermal expansion coefficients by means of a simple constitution and which improves the temperature characteristic.

In the drawings:
Fig. 1A shows an upper view and a lateral cross-sectional view of a first embodiment of the acceleration sensor according to the present invention;
Fig. 1B illustrates the joint between a sensor base and a mount of the first embodiment;
Fig. 1C is a temperature characteristic diagram of the first embodiment;
Fig. 2A is a diagram showing an upper view and lateral cross-sectional view of a second embodiment of the acceleration sensor according to the present invention;
Fig. 2B illustrates the joint between the sensor base and mount of the second embodiment;
Fig. 2C is a temperature characteristic diagram of the second embodiment;
Fig. 3 shows an enlargement of the planar view (I) of Fig. 2A;
Fig. 4A is an example in which the interval of the individual joint portions 7a is determined so that this interval has the same size as the inter-joint gap 9 of the first embodiment;
Fig. 4B is an example in which the interval of individual joint portions 7a is determined under the condition of making the temperature drift 0 in the second embodiment;
Fig. 5A shows the third embodiment in an oblique view;
Fig. 5B illustrates the length of the space groove of the third embodiment;
Fig. 5C is a temperature characteristic diagram of the third embodiment;
Fig. 6A shows the fourth embodiment in an oblique view;
Fig. 6B illustrates the height of the space groove of the fourth embodiment;
Fig. 7A is a modified example of the fourth embodiment that shows an example in which a space groove is located on the surface side of the sensor base as a fifth embodiment;
Fig. 7B is a modified example of the fourth embodiment that shows an example in which space grooves are located on the lower and surface sides of the sensor base as a fifth embodiment;
Fig. 8 is a sixth embodiment, in which a second groove is further provided;
Fig. 9 is a seventh embodiment according to the present invention;
Fig. 10A shows a first example in which the acceleration sensor according to the present invention is packaged;
Fig. 10B shows a second example in which the acceleration sensor according to the present invention is packaged;
Fig. 10C shows a third example in which the acceleration sensor according to the present invention is packaged; and
Fig. 10D shows a fourth example in which the acceleration sensor according to the present invention is packaged.

Embodiments of the present invention will be described herein below with reference to the drawings. Further, the embodiments permit an understanding of the present invention and the technological scope of the present invention is not limited to these embodiments.

### First Embodiment

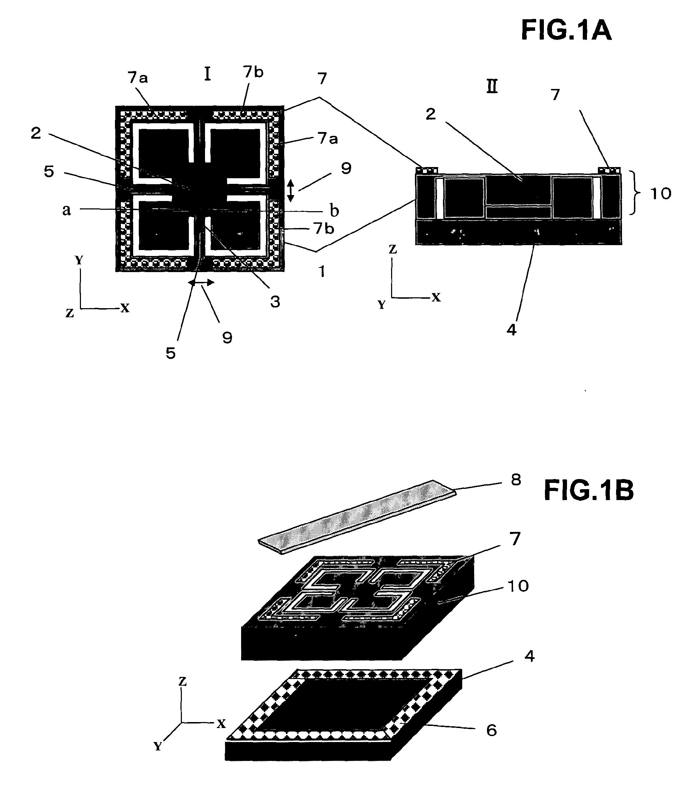

A first embodiment of the present invention is shown in Figs. 1A to 1C. Fig. 1A shows an upper view (Fig. 1A, I) of the acceleration sensor according to the present invention and a lateral cross-sectional view (Fig. 1A, II) thereof along the line a-b. The acceleration sensor is produced by integrally forming a frame 1 having four sides that enclose a circumference, a weight portion 2 that is positioned within the frame 1, and beam portions 3 that are formed between the frame 1 and weight portion 2 by means of a semiconductor substrate as a sensor base 10. Further, the reverse side of the sensor base 10 is fixed mounted on a mount 4 constituting package material such as glass or alumina ceramic.

In this constitution, when stress is applied to the weight portion 2 vertically or in a lateral direction, the beam portions 3 produce flexure that corresponds with the stress. It is possible to detect this flexure as strain by means of detection elements 5 that are formed on the beam portions 3 and thereby determine the acceleration that produces the stress.

Fig. 1B illustrates the joint between the sensor base 10 and the mount 4 of the first embodiment. The sensor base 10 and mount 4 are joined through anode bonding or a resin or the like by means of a joint portion 6 that is formed on the periphery of the mount 4.

Meanwhile, the surface side of the sensor base 10 is covered by a stopper substrate 8 of glass or alumina ceramic similarly viapads (joint portions) 7 of an electrically conductive material such as Al in order to draw out electrodes that are connected to leads (not shown) that are derived from the detection element 5. The stopper substrate 8 may be a flat plate of a size corresponding with the base 10 or may be formed with a beam shape as shown in Fig. 1B, the two ends of which may be fixed on the diagonals of the base 10.

Here, in this constitution, the mount 4 on which the sensor base 10 is mounted and fixed also has the function of limiting, together with the stopper substrate 8, the movement of the weight portion 2 in a vertical direction.

However, the difference in the thermal expansion coefficients of the joint portions 6 and 7 and the sensor base 10 constituting the semiconductor substrate is a problem. In other words, thermal stress is produced as a result of this difference in the thermal expansion coefficients. Accordingly, strain acts on the beam portions 3 even in a 0G state where acceleration is not applied and a signal (known as an 'offset drift' herein below) is produced by the detection element 5. Further, although one method for resolving this offset drift has been proposed in Japanese Patent Application No. 2000-304762, which was described earlier as a conventional example, this constitution is one in which thermal stress that arises from the difference in the thermal expansion coefficients of the frame 1 and joint portions 7 is readily produced in the beam portions 3.

Therefore, the present invention resolves this inconvenience.

In the case of the first embodiment, a feature of the present invention is that of a constitution having a pair of joint portions 7a and 7b that are formed with a gap there between on each of the four sides of the frame 1.

Fig. 1C is a temperature characteristic diagram of the first embodiment and is a graph with plotted values that are rendered by normalizing, by means of the offset voltage when the temperature is 25°C, themaximumoffset voltage when the temperature is changed from -45°C to +85°C in each of the gaps when the inter-joint gap 9 is widened from a state where there is no gap, that is from a 0 gap.

As shown in Fig. 1C, it can be seen that, the larger the inter-joint gap 9, the smaller the normalized offset voltage becomes.

Thus, in the case of the first embodiment of the present invention, the joint portion 7 is formed in the plane (X-Y plane) of the frame 1 and the inter-joint gap 9 is formed in a direction that is orthogonal to the asymmetrical center in the longitudinal direction of the beam portions 3. As a result, the thermal stress produced by the difference in the linear expansion coefficients of the joint portions 7 and the semiconductor substrate can be suppressed and the temperature offset drift can be suppressed.

Further, as a supplementary effect, the whole surface of the frame 1 can be fixed to the mount 4 by means of the joint portion 6 between the mount 4 and the sensor base 10 shown in Fig. 1B. As a result, the first embodiment also exhibits superior shock resistance.

### Second Embodiment

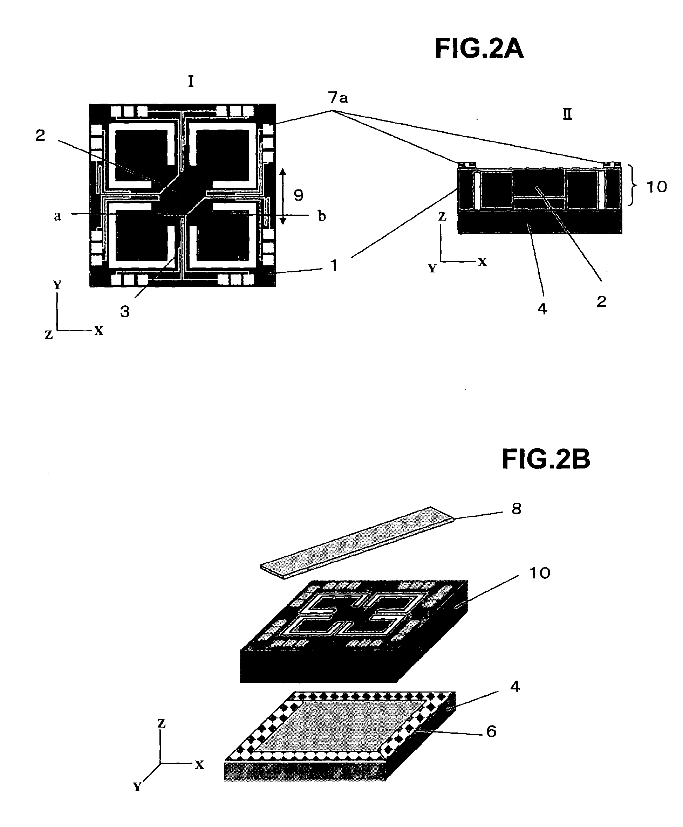

Figs. 2A, 2B, and 2C show the second embodiment of the present invention and correspond to Figs. 1A, 1B, and 1C respectively.

Therefore, in Figs. 2A and 2B, reference numerals that are the same as those in Figs. 1A and 1B denote the same parts. However, unlike the joint portions 7 of the first embodiment, the second embodiment has a form with a plurality of individual j oint portions 7a.

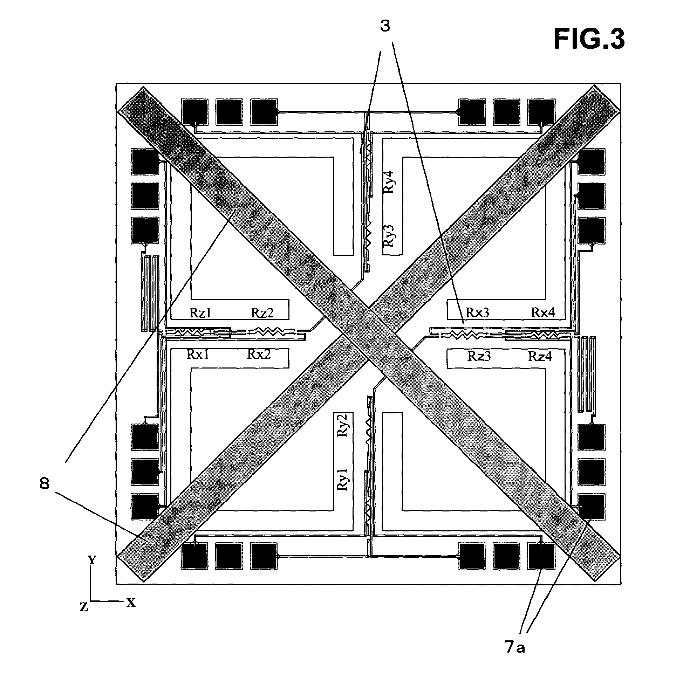

Fig. 3 shows an enlargement of the planar view (I) of Fig. 2A. Further, Fig. 3 shows an example in which, unlike Fig. 2B, the stopper substrate 8 is afforded an X shape and four terminals are fixed in the four corners of the base 10.

In Fig. 3, piezoresistors Rx1 to Rx4 for detecting the acceleration in the direction of the X axis, piezoresistors Ry1 to Ry4 for detecting the acceleration in the direction of the Y axis and piezoresistors Rz1 to Rz4 for detecting the acceleration in the direction of the Z axis are formed on the beam portions 3.

Further, the two terminals of these piezoresistors are connected to individual joint portions 7a constituting corresponding electrode pads via leads. Further, although there are also individual joint portions 7a that are not connected to piezoresistors in Fig. 3, these are dummy pads for holding the stress balance on the respective sides.

In an external circuit (not shown) that is derived from the individual joint portions 7a, a Wheatstone bridge is put together and the amount of strain of the beam portions 3 is sensed as acceleration. The circuit constitution for this detection is not directly related to the present invention and therefore an additional description is omitted here.

The description will now continue by returning to Fig. 2C. Similarly to Fig. 1C, Fig. 2C is a graph with plotted values that are rendered by normalizing, by means of the offset voltage when the temperature is 25°C, the maximum offset voltage when the temperature is changed from -45°C to +85°C in the respective inter-joint gaps 9.

In Fig. 2C, graph A is the characteristic of the first embodiment and is the same as Fig. 1C. On the other hand, graph B shows the characteristic of the second embodiment. It can be seen from the graph shown in Fig. 2C that, in the case of the second embodiment, the variation in the normalized offset voltage when the inter-joint gap 9 is increased is large. That is, it can be seen that, in the case of the second embodiment, the temperature drift can be suppressed more than in the case of the first embodiment even when the same inter-joint gap 9 is provided.

Therefore, under the condition that the temperature drift should be 0, the second embodiment makes it possible to reduce the inter-joint gap 9 further than the first embodiment does (See the double arrow section C in Fig. 2C).

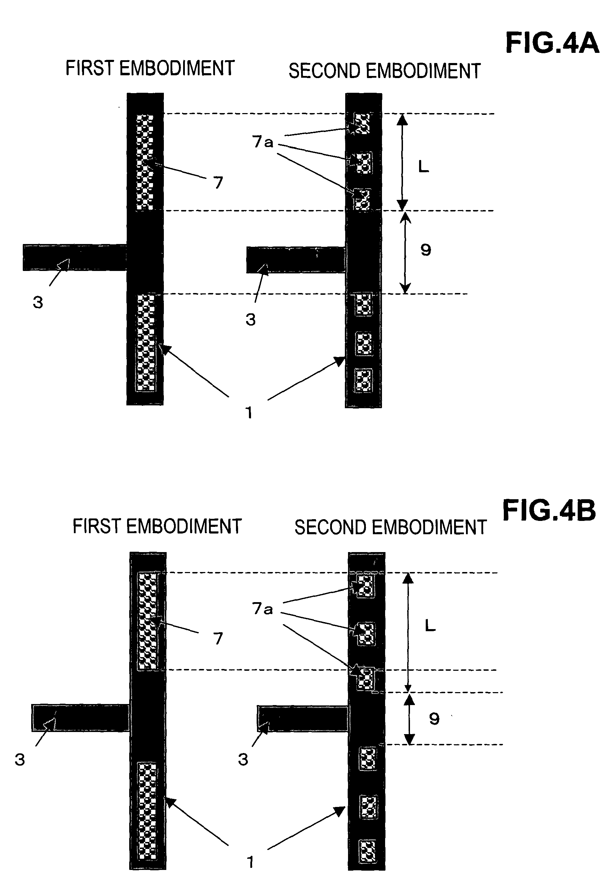

Figs. 4A and 4B further illustrate the grounds for being able to increase the joint length L by being able to reduce the inter-joint gap 9 during a comparison with this first embodiment.

Fig. 4A is an example in which the inter-joint gap 9 of the first embodiment is of the same size and therefore the gap between the individual joint portions 7a is determined so that this interval has the same joint length L as the first embodiment. In this case also, as shown in Fig. 2C, the second embodiment exhibits a smaller normalized offset voltage than the case of the first embodiment.

Fig. 4B is an example in which, in the second embodiment, the interval of individual joint portions 7a is determined to afford a smaller gap than the inter-joint gap 9 of the first embodiment under the condition of making the temperature drift 0. Because the inter-joint gap 9 is small in comparison with Fig. 4A, the joint length L can be increased.

### Third Embodiment

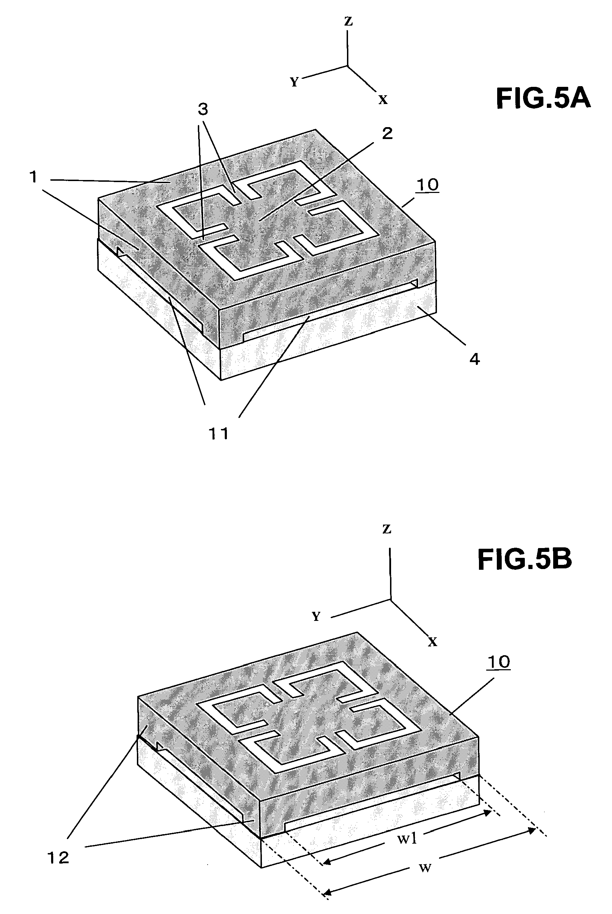

Figs. 5A to 5C illustrate the third embodiment according to the present invention. The same reference numerals as those of the earlier first and second embodiments indicate the same parts.

The third embodiment comprises the features of the earlier first or second embodiment and comprises a space groove 11 between the mount 4 and sensor base 10 as an additional feature. Here, as per the earlier first and second embodiments, the mount 4 comprises a package and a substrate with electrically conductive joint portions such as a circuit substrate.

The joining of the sensor base 10 to the mount 4 is executed by joining column portions 12 formed in the corners of the four sides by means of anode bonding or resin or the like. The width of the space groove 11 that exists between the mount 4 and sensor base 10 as a result of the columns 12 is the length between two columns 12 in two corners.

Here, as shown in Fig. 5B, the length between two columns 12, that is, the width of the space groove 11, is W1, and the length of one side of the sensor base 10 is W. Fig. 5C is a graph showing the variation in the offset voltage with respect to the ratio W1/W. This is a graph on which the maximum offset variation (voltage) when the temperature is changed from -45°C to +85°C in the ratio between the respective W1/W is plotted.

As may be seen from Fig. 5C, in the third embodiment, by adjusting the ratio W1/W, the thermal stress that is produced and which arises from the difference in the linear expansion coefficients can be adjusted and the offset drift can be suppressed, as mentioned in the earlier embodiments.

### Fourth Embodiment

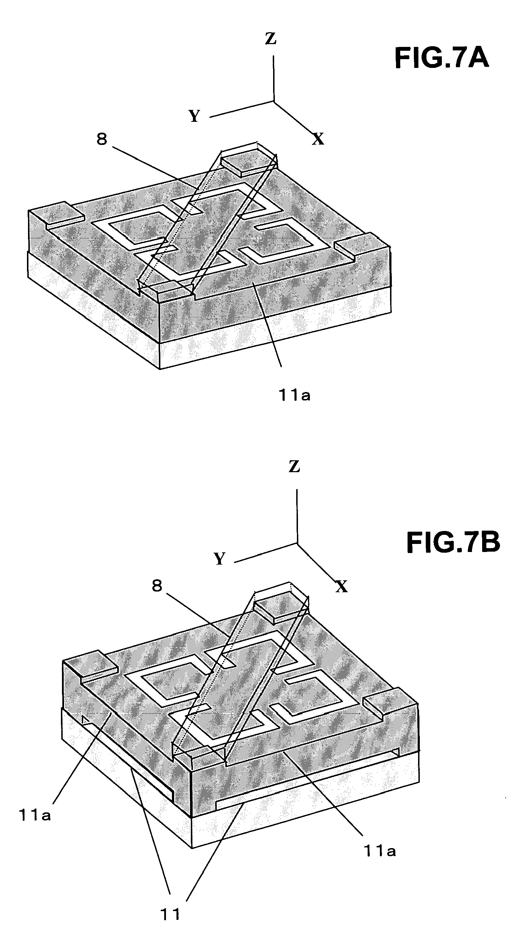

Fig. 6A is the fourth embodiment according to the present invention. This embodiment resolves the problem arising from the difference in the thermal expansion coefficients by making the offset variation 0 by changing the height t1 of the space groove 11, the height T of the sensor base 10 and the ratio t1/T in the third embodiment.

That is, Fig. 6B is a graph on which the maximum offset variation (voltage) when the length W1 of the space groove 11 is set substantially equal to the width of the beam portions 3, the ratio t1/T is changed, and the temperature is varied from -45°C to +85°C. It can be seen from Fig. 6B that there is no effect on the temperature variation as a result of establishing the height t1 of the space groove 11 at or above a fixed height.

### Fifth Embodiment

Figs. 7A and 7B are examples of extensions of the third embodiment in Fig. 5A. An example in which a space groove 11a corresponding with the space groove 11 that is formed in the embodiment of Fig. 5A is formed in the surface side of the sensor base 10 and a space is provided between the surface side and the stopper substrate 8 is shown in Fig. 7A. Further, the example shown in Fig. 7B is an embodiment that comprises both the space groove 11 and the space groove 11a.

Thermal stress that is produced as a result of the difference in the thermal expansion coefficients when a cover or circuit substrate, a package, and a substrate that comprises electrically conductive joint portions are electrically or mechanically joined to the surface side and reverse side of the frame 1 of the sensor base 10 affects the detection element, and an offset drift is produced. However, by reducing the thermal stress of the joint portions 7 and 7a by also forming the space grooves 11 and 11a in the frame according to the constitution shown in the Figs. 7A and 7B, it is possible to suppress the effect of thermal stress on the beam portions 3 and, therefore, on the detection elements 5 and suppress the temperature offset drift.

### Sixth Embodiment

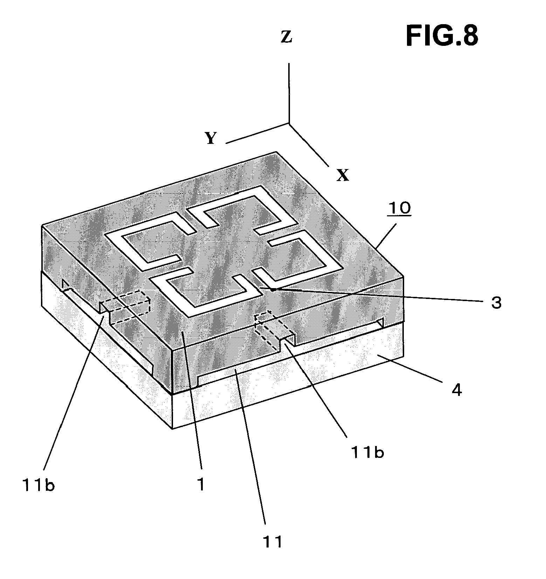

Fig. 8 is yet another sixth embodiment according to the present invention. In the embodiment shown in Fig. 8, second grooves 11b are formed in the reverse side of the frame 1 in directions that match the vertical directions of the space grooves 11, in the center of the space grooves 11 that constitute recesses in the frame 1 provided between the sensor base 10 and mount 4 shown in Figs. 5A to Fig. 7B.

As a result of this constitution, the above-mentioned thermal stress can be suppressed by the first space groove 11 and the effect of thermal stress on the detection element 4 can be suppressed further while retaining the overall strength of the frame 1 by means of the second space groove 11b with a narrow groove width. A third groove is similarly formed in a vertical direction in the space groove 11a in the surface as well as in the reverse side of the frame 1. Here, the width of the space groove 11b is substantially the same as the width of the beam portions 3.

### Seventh Embodiment

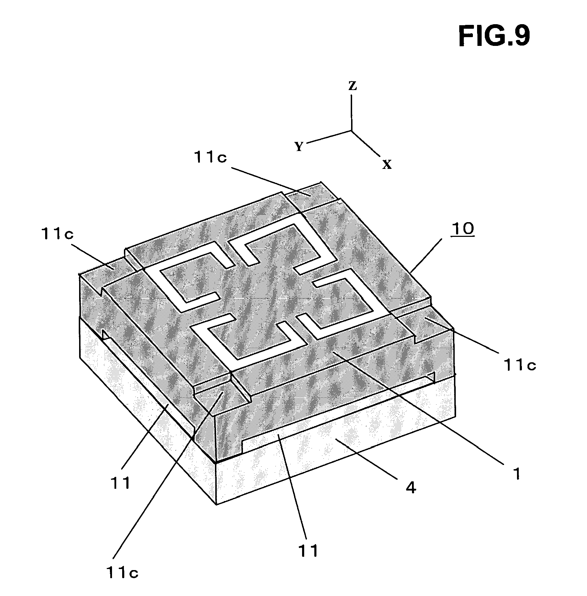

Fig. 9 is a further seventh embodiment according to the present invention. In the embodiment shown in Fig. 9, groove portions 11c are provided in correspondence with the column portions 12 in the four corners of the frame 1 on the surface side of the sensor base 10 shown in Figs. 5A to 7B. As a result of this constitution, the thermal stress of the four angular parts of the frame 1 in which thermal stress is readily produced is reduced. Accordingly, it is possible to suppress the effect of thermal stress on the beam portions 3 and, therefore, on the detection element 5 and suppress the temperature offset drift.

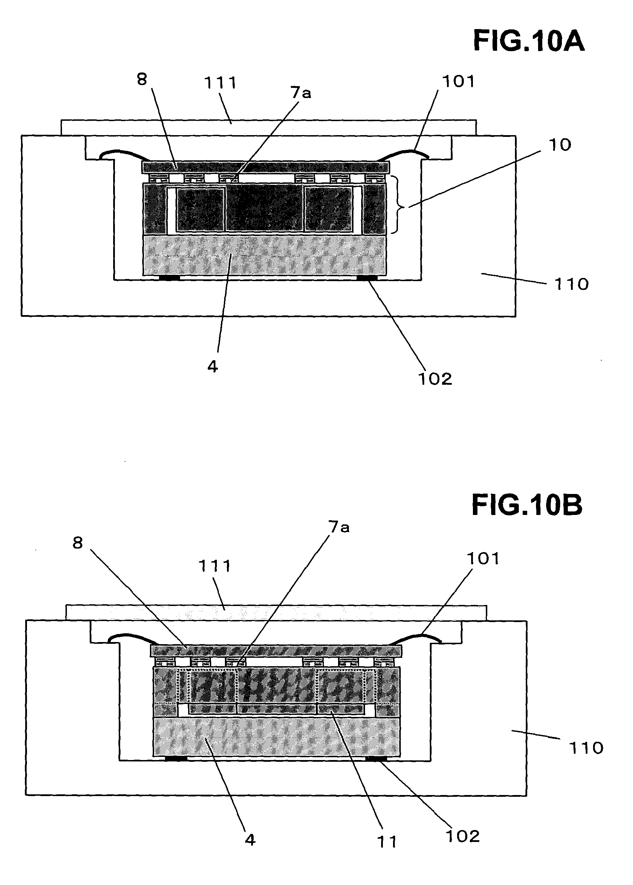

Figs. 10A to 10D show an embodiment in which the acceleration sensor according to the present invention is packaged.

Fig. 10A is an example in which the sensor of the second embodiment shown in Figs. 2A and 2B is housed in a package that is formed by a package main body 110 and a package lid portion 111 and provides a lateral cross-sectional view thereof.

This is a constitution in which electrical power is supplied from the outside by means of electrically conductive wire 101 that is connected to the block of the package main body 110 or a detection signal is extracted to the outside. The mount 4 is a circuit substrate and a processor element for determining the acceleration by processing the detection signal of the detection element 5 can also be installed.

In addition, the mount 4 and the bottom face of the package 110 are electrically connected by means of electrically conductive resin 102, and the circuit operation can be stabilized and the effects of external noise can be avoided by fixing the mount 4 and the bottom face of the package 110 at ground potential.

Fig. 10B is an example in which the sensor of the embodiment of Fig. 5A is housed in the package 110 and comprises the space groove 11 between the sensor base 10 and mount 4. The remaining constitution is as described in Fig. 10A.

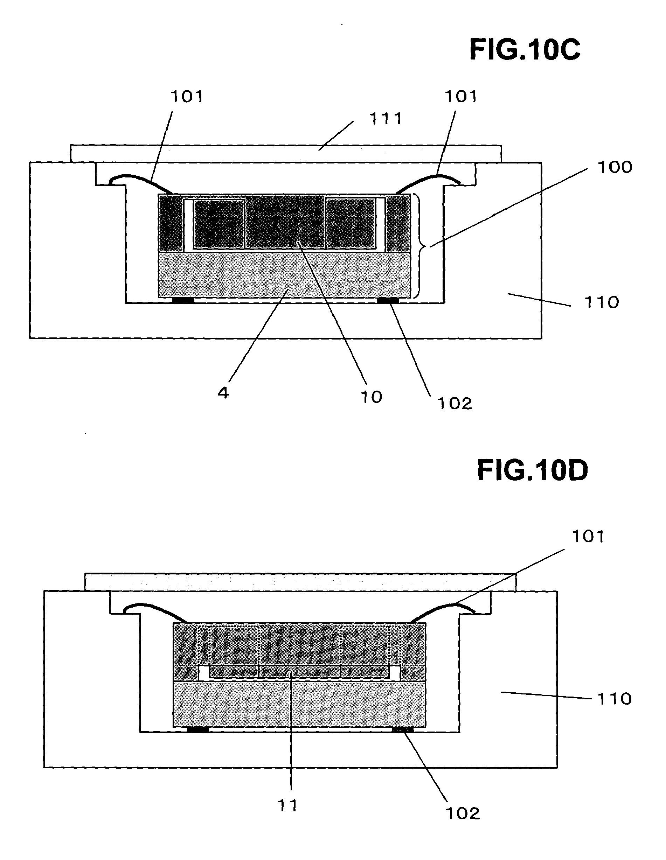

Figs. 10C and 10D correspond to Figs. 10A and 10B respectively but are examples in which the stopper substrate 8 of the sensor is omitted.

Further, Figs. 10A and 10D have the space groove 11 between the sensor base 10 and mount 4 but it is understood that the same may be true of the other embodiments of Figs. 7A, 7B, and Fig. 8.

As per the description of the embodiments above, the present invention is able to provide an acceleration sensor with reduced noise which resolves the problem of stress that arises from the difference in the thermal expansion coefficients. Therefore, when the acceleration sensor according to the present invention is integrated into a device performing control that is related to acceleration, highly reliable acceleration control is rendered possible and a substantial contribution to industry is accordingly provided.

## Claims

1. An acceleration sensor that detects acceleration in three-axis directions in a three-dimensional coordinate system, comprising:
a frame having four sides that is integrally formed by a semiconductor substrate;
a weight portion that is positioned within the frame;
four beam portions, corresponding with each of the four sides, one end of which is connected to the weight portion to support the weight portion and the other end of which is connected to the center of the corresponding side of the four sides;
detection elements, each of which is formed on each of the four beam portions and detects flexure of the beam portions that corresponds to the acceleration acting on the weight portion; and
a pair of joint portions that are formed with a gap there between are formed on each of the four sides of the frame,
the gap between the pair of joint portions formed on one side having a predetermined length with the center of the one side as the point of symmetry.

2. The acceleration sensor according to claim 1, wherein each of the pair of joint portions comprises a plurality of electrode terminals connected to an electrode lead that is linked to the detection element, and the plurality of electrode elements are disposed at equal intervals along the corresponding side.

3. The acceleration sensor according to claim 1 or 2, wherein the offset voltage that is detected by the detection element is adjusted by means of the size of the gap between the pair of joint portions.

4. The acceleration sensor according to claim 1,2,or 3, wherein the frame has a predetermined thickness and comprises, on each of the four sides thereof, a recess, in which a region that is narrower than the predetermined thickness is formed uniformly to a predetermined length along the side of the frame on the opposite side from the face where the pair of joint portions is formed; and
the recess, which is joined to a mount opposite the opposite side, forms a space groove that is between the substrate and the frame.

5. The acceleration sensor according to claim 1,2,or 3, wherein the frame has a predetermined thickness and is formed by means of a recess in which at least a region where the pair of joint portions is formed uniformly to a predetermined length that is narrower than the predetermined thickness along a side of the frame; and
the recess, which is joined to a stopper substrate opposite the pair of joint portions, forms a space groove that is between the stopper substrate and the frame.

6. The acceleration sensor according to claim 4, wherein the mount that is joined to the frame is a circuit substrate, a package bottom portion or a package cover.

7. The acceleration sensor according to claim 4 or 5, wherein the offset voltage that is detected by the detection element is adjusted by means of the predetermined length of the recess.

8. The acceleration sensor according to claim 4 or 5, wherein a groove portion is also formed in the reverse side of the frame in a direction that matches the vertical direction of the space grooves, in the center of the recess of the frame.

9. The acceleration sensor according to claim 4 or 5, wherein groove portions are formed in positions corresponding with the four corners of the frame on the surface side of the frame.
